# EUROPEAN PATENT APPLICATION

(11) **EP 4 447 032 A1**
(43) Date of publication of application: **16.10.2024**
(21) Application number: 22960307.1
(22) Date of filing: 30.09.2022
(51) Int. Cl.: G09G 3/32, G09G 3/3208

(54) **DISPLAY SUBSTRATE, DISPLAY MODULE, AND DISPLAY DEVICE**

(71) Applicant: Boe Technology Group Co., Ltd., Beijing 100015 (CN); Chengdu BOE Optoelectronics Technology Co., Ltd., Chengdu, Sichuan 611731 (CN)
(72) Inventor: DU, Lili, Beijing 100176 (CN); WANG, Benlian, Beijing 100176 (CN); HUANG, Weiyun, Beijing 100176 (CN); XU, Yuanjie, Beijing 100176 (CN)
(74) Representative: Hoffmann Eitle
(86) International application number: PCT/CN2022/123298
(87) International publication number: WO 2024/065688

(57) **Abstract**

A display substrate (100), comprising: N first light-emitting device groups (10) that are located in a first display area (A) and are sequentially arranged in a first direction (X); N first pixel circuit groups (20) that are located in a second display area (B) and are sequentially arranged in the first direction (X); and a wiring group (30) connected to one first light-emitting device group (10) and one first pixel circuit group (20). Each first light-emitting device group (10) comprises M first light-emitting devices (P1) sequentially arranged in the first direction (X), each first pixel circuit group (20) comprises M first pixel circuits (C1) sequentially arranged in the first direction (X), and the wiring group (30) comprises M wirings (L) that are arranged in parallel. The N first pixel circuit groups (20) are located on the same side of the N first light-emitting device groups (10), N ≥ 2, M ≥ 2, and N and M are integers. The 1st first light-emitting device group (10₁) is electrically connected to one first pixel circuit group (20) other than the 1st first pixel circuit group (20₁), and/or the Nth first light-emitting device group (10_{N}) is electrically connected to one first pixel circuit group (20) other than the Nth first pixel circuit group (20_{N}).

## Description

### TECHNICAL FIELD

The present disclosure relates to the field of display technologies, and in particular, to a display substrate, a display module and a display apparatus.

### BACKGROUND

With the further development of display technology, display substrates with full screens have become the development trend of future display technology. Essential functional components such as front cameras have become a major factor limiting the full screens.

Full Display with Camera (FDC) technology refers to placing the front cameras under the display substrates to increase the display areas of the display substrates. When the front camera does not work, the part of the display substrate located on the front camera can also display images normally, thus achieving a full-screen display effect.

### SUMMARY

In an aspect, a display substrate is provided. The display substrate has a first display region and a second display region, and the second display region surrounds at least a part of the first display region. The display substrate includes: N first light-emitting device groups located in the first display region and arranged sequentially in a first direction, N first pixel circuit groups located in the second display region and arranged sequentially in the first direction, and a wire group connecting the first light-emitting device group and the first pixel circuit group. The N first pixel circuit groups are located on the same side of the N first light-emitting device groups. The first light-emitting device group includes M first light-emitting devices arranged sequentially in the first direction; in a positive direction of the first direction, the N first light-emitting device groups are respectively 1st to Nth first light-emitting device groups, and the M first light-emitting devices are respectively 1st to Mth first light-emitting devices; and N is greater than or equal to 2, M is greater than or equal to 2, and N and M are both integers. The pixel circuit group includes M first pixel circuits arranged sequentially in the first direction; in a negative direction of the first direction, the N first pixel circuit groups are 1st to Nth first pixel circuit groups respectively, and the M first pixel circuits are 1st to Mth first pixel circuits respectively. The wire group includes M wires arranged in parallel; an ith first light-emitting device in the first light-emitting device group is electrically connected to an ith first pixel circuit in the first pixel circuit group through an ith wire; and i is in a range of 1 to M, inclusive. The 1st first light-emitting device group is electrically connected to a first pixel circuit group other than the 1st first pixel circuit group; and/or, the Nth first light-emitting device group is electrically connected to a first pixel circuit group other than the Nth first pixel circuit group.

In some embodiments, wires electrically connected to the same first light-emitting device group are located in the same layer; and wires electrically connected to different first light-emitting device groups are located in different layers.

In some embodiments, orthographic projections of the M wires in the same wire group on a plane where the display substrate is located do not overlap.

In some embodiments, a length of the ith wire among the M wires in the same wire group and a distance between the ith first light-emitting device and the ith first pixel circuit are equal or differ by a preset length.

In some embodiments, a sequence of lengths of the M wires is in an arithmetic progression.

In some embodiments, a Pth first light-emitting device group is electrically connected to an (N-P+1)th first pixel circuit group through a corresponding wire group, P being in a range of 1 to N, inclusive.

In some embodiments, the display substrate includes two repeating units located in the first display region and arranged sequentially in the first direction, and each repeating unit includes N first light-emitting device groups; the two repeating units are respectively located on two sides of a reference line; and the reference line is a straight line extending in a second direction and passing through the first display region, the second direction being perpendicular to the first direction. First pixel circuit groups electrically connected to the two repeating units are located on two sides of the first display region in the first direction, respectively. Wire groups electrically connected to the two repeating units are located on the two sides of the reference line, respectively. The first display region has a center, and the reference line passes through the center.

In some embodiments, the two repeating units each include the same number of first light-emitting device groups.

In some embodiments, wires electrically connected to a jth first light-emitting device group in each repeating unit are located in the same layer; and j is in a range of 1 to N, inclusive.

In some embodiments, the display substrate includes: two columns of repeating units located in the first display region and arranged sequentially in the first direction, and each column of repeating units includes: at least two rows of repeating units arranged sequentially in the second direction. First pixel circuit groups electrically connected to the same column of repeating units are located on the same side of the first display region and arranged sequentially in the second direction. Wire groups electrically connected to the same column of repeating units are arranged sequentially in the second direction.

In some embodiments, in the same column of repeating units, wires electrically connected to a jth first light-emitting device group in each row of repeating units are located in the same layer; and j is in a range of 1 to N, inclusive.

In some embodiments, a number of first light-emitting devices included in each first light-emitting device group is the same.

In some embodiments, the first light-emitting device group and the first pixel circuit group electrically connected thereto are arranged in the same row. A main body portion of each wire in the wire group extends in the first direction.

In some embodiments, the display substrate includes: a substrate, a pixel circuit layer disposed on a side of the substrate, a light-emitting device layer disposed on a side of the pixel circuit layer away from the substrate, and a plurality of wire layers disposed between the pixel circuit layer and the light-emitting device layer and stacked in sequence. The N first pixel circuit groups are located in the pixel circuit layer; the N first light-emitting device groups are located in the light-emitting device layer; one wire group is located in one wire layer; and a material of the plurality of wire layers includes a light-transmissive conductive material.

In some embodiments, a number of the plurality of wire layers is the same as a number of the N first light-emitting device groups.

In some embodiments, the display substrate further includes: a plurality of second pixel circuits located in the second display region, and a plurality of second light-emitting devices located in the second display region and electrically connected to the plurality of second pixel circuits. In the first pixel circuit group, at least one second pixel circuit is disposed between two adjacent first pixel circuits.

In another aspect, a display module is provided, including: the display substrate as described in any of the above embodiments, and an image acquisition device disposed on a non-light-exiting side of the display substrate and located in the first display region of the display substrate.

In yet another aspect, a display apparatus is provided, including the display module as described in any of the above embodiments.

### BRIEF DESCRIPTION OF THE DRAWINGS

In order to describe technical solutions in the present disclosure more clearly, the accompanying drawings to be used in some embodiments of the present disclosure will be introduced briefly. However, the accompanying drawings to be described below are merely drawings of some embodiments of the present disclosure, and a person of ordinary skill in the art can obtain other drawings according to those drawings. In addition, the accompanying drawings to be described below may be regarded as schematic diagrams, and are not limitations on actual sizes of products involved in the embodiments of the present disclosure.
FIG. 1 is a structural diagram of a display substrate, in accordance with some embodiments of the present disclosure;
FIG. 2 is a structural diagram of another display substrate, in accordance with some embodiments of the present disclosure;
FIG. 3 is a structural diagram of yet another display substrate, in accordance with some embodiments of the present disclosure;
FIG. 4 is a sectional view taken along the line C-C' in FIG. 3;
FIG. 5 is a sectional view taken along the line D-D' in FIG. 3;
FIG. 6 is a structural diagram of yet another display substrate, in accordance with some embodiments of the present disclosure;
FIG. 7 is a structural diagram of yet another display substrate, in accordance with some embodiments of the present disclosure;
FIG. 8 is a structural diagram of yet another display substrate, in accordance with some embodiments of the present disclosure;
FIG. 9 is a structural diagram of yet another display substrate, in accordance with some embodiments of the present disclosure;
FIG. 10 is a structural diagram of yet another display substrate, in accordance with some embodiments of the present disclosure;
FIG. 11 is a structural diagram of yet another display substrate, in accordance with some embodiments of the present disclosure;
FIG. 12 is a structural diagram of yet another display substrate, in accordance with some embodiments of the present disclosure;
FIG. 13 is a structural diagram of yet another display substrate, in accordance with some embodiments of the present disclosure;
FIG. 14 is a structural diagram of yet another display substrate, in accordance with some embodiments of the present disclosure;
FIG. 15 is a structural diagram of a display module, in accordance with some embodiments of the present disclosure; and
FIG. 16 is a structural diagram of a display apparatus, in accordance with some embodiments of the present disclosure.

### DETAILED DESCRIPTION

The technical solutions in some embodiments of the present disclosure will be described clearly and completely with reference to the accompanying drawings. However, the described embodiments are merely some but not all of embodiments of the present disclosure. All other embodiments obtained on the basis of the embodiments of the present disclosure by a person of ordinary skill in the art shall be included in the protection scope of the present disclosure.

Unless the context requires otherwise, throughout the description and claims, the term "comprise" and other forms thereof such as the third-person singular form "comprises" and the present participle form "comprising" are construed as an open and inclusive meaning, i.e., "included, but not limited to". In the description of the specification, terms such as "one embodiment", "some embodiments", "exemplary embodiments", "example", "specific example" or "some examples" are intended to indicate that specific features, structures, materials or characteristics related to the embodiment(s) or example(s) are included in at least one embodiment or example of the present disclosure. Schematic representations of the above terms do not necessarily refer to the same embodiment(s) or example(s). In addition, specific features, structures, materials, or characteristics described herein may be included in any one or more embodiments or examples in any suitable manner.

Hereinafter, the terms such as "first" and "second" are used for descriptive purposes only, but are not to be construed as indicating or implying the relative importance or implicitly indicating the number of indicated technical features. Thus, features defined with "first" and "second" may explicitly or implicitly include one or more of the features. In the description of the embodiments of the present disclosure, the terms "a plurality of", "the plurality of" and "multiple" each mean two or more unless otherwise specified.

Some embodiments may be described using the terms "coupled" and "connected" and their derivatives. For example, the term "connected" may be used in the description of some embodiments to indicate that two or more components are in direct physical or electrical contact with each other. The embodiments disclosed herein are not necessarily limited to the content herein.

The phrase "A and/or B" includes the following three combinations: only A, only B, and a combination of A and B.

In addition, the use of the phrase "based on" is meant to be open and inclusive, since a process, step, calculation or other action that is "based on" one or more of the stated conditions or values may, in practice, be based on additional conditions or values exceeding those stated.

The term such as "about", "substantially" or "approximately" as used herein includes a stated value and an average value within an acceptable range of deviation of a particular value determined by a person of ordinary skill in the art, considering measurement in question and errors associated with measurement of a particular quantity (i.e., limitations of a measurement system).

The term such as "parallel", "perpendicular" or "equal" as used herein includes a stated case and a case similar to the stated case within an acceptable range of deviation determined by a person of ordinary skill in the art, considering measurement in question and errors associated with measurement of a particular quantity (i.e., limitations of a measurement system). For example, the term "parallel" includes absolute parallelism and approximate parallelism, and an acceptable range of deviation of the approximate parallelism may be, for example, a deviation within 5°; the term "perpendicular" includes absolute perpendicularity and approximate perpendicularity, and an acceptable range of deviation of the approximate perpendicularity may also be, for example, a deviation within 5°. The term "equal" includes absolute equality and approximate equality, and an acceptable range of deviation of the approximate equality may be, for example, that a difference between two equals is less than or equal to 5% of either of the two equals.

It will be understood that, when a layer or element is referred to as being on another layer or substrate, it may be that the layer or element is directly on the another layer or substrate, or it may be that intervening layer(s) exist between the layer or element and the another layer or substrate.

Exemplary embodiments are described herein with reference to sectional views and/or plan views as idealized exemplary drawings. In the drawings, thicknesses of layers and sizes of regions are enlarged for clarity. Variations in shapes relative to the accompanying drawings due to, for example, manufacturing technologies and/or tolerances may be envisaged. Therefore, the exemplary embodiments should not be construed to be limited to the shapes of regions shown herein, but to include deviations in the shapes due to, for example, manufacturing. For example, an etched region shown in a rectangular shape generally has a feature of being curved. Therefore, the regions shown in the accompanying drawings are schematic in nature, and their shapes are not intended to show actual shapes of regions in a device, and are not intended to limit the scope of the exemplary embodiments.

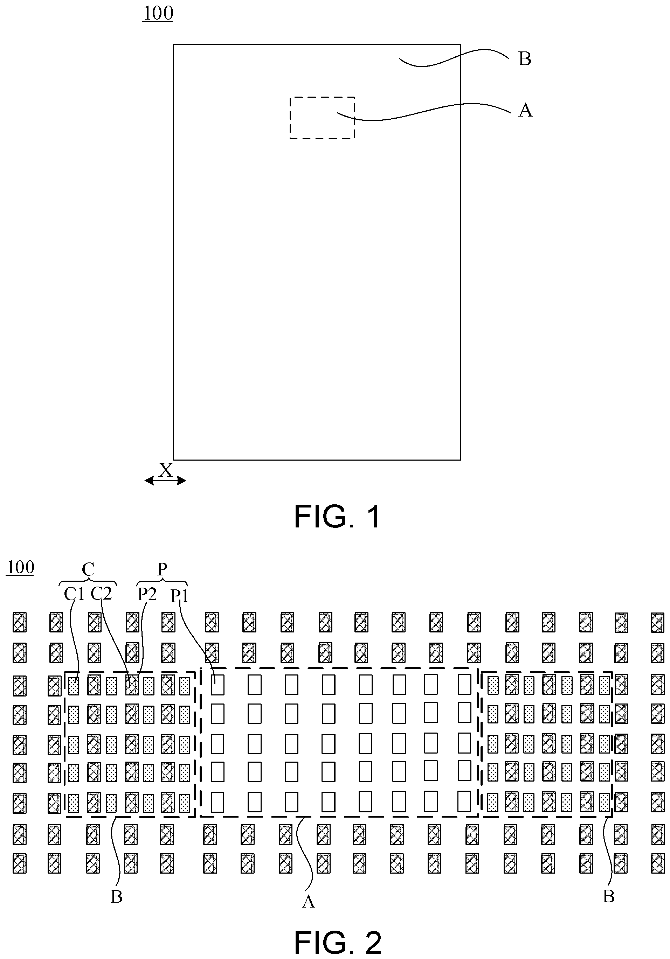

As shown in FIG. 1, some embodiments of the present disclosure provide a display substrate 100. The display substrate 100 has a first display region A and a second display region B. The second display region B surrounds at least a part of the first display region A.

For example, the second display region B surrounds a part of the first display region A, that is, a part of a boundary of the second display region B coincides with a part of a boundary of the first display region A.

For example, in a direction parallel to a plane where the display substrate 100 is located, the second display region B and the first display region A are arranged sequentially.

For example, as shown in FIG. 1, the second display region B encloses the first display region A, that is, the second display region B surrounds the first display region A.

For example, the first display region A is located inside the second display region B.

For example, as shown in FIG. 1, an area of the first display region A is less than an area of the second display region B.

A shape of the first display region A is not limited in the present disclosure, which can be determined according to actual needs.

For example, a shape of the first display region A includes any one of a circle, an ellipse, and a polygon. The polygon may be, for example, a quadrilateral, a pentagon, or a hexagon. The quadrilateral includes, for example, a rectangle.

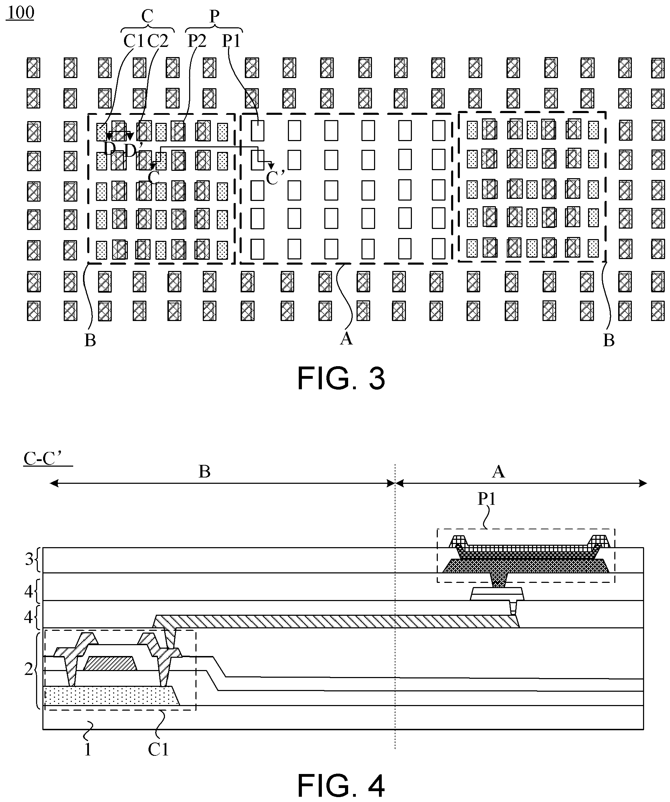

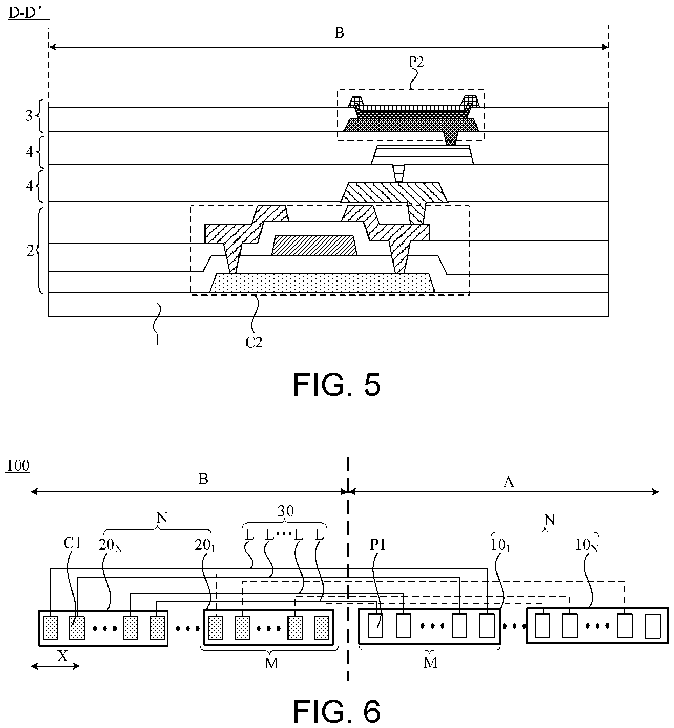

In some examples, as shown in FIGS. 4 and 5, the display substrate 100 includes: a substrate 1, a pixel circuit layer 2 disposed on a side of the substrate 1, and a light-emitting device layer 3 disposed on a side of the pixel circuit layer 2 away from the substrate 1.

A structure of the substrate 1 varies, which may be determined according to actual needs.

For example, the substrate 1 may be a rigid substrate. The rigid substrate may be, for example, a glass substrate or a polymethyl methacrylate (PMMA) substrate. In this case, the display substrate 100 may be a rigid display substrate.

For example, the substrate 1 may be a flexible substrate. The flexible substrate may be, for example, a polyethylene terephthalate (PET) substrate, a polyethylene naphthalate (PEN) substrate or a polyimide (PI) substrate. In this case, the display substrate 100 may be a flexible display substrate.

For example, the pixel circuit layer 2 includes a plurality of pixel circuits C.

The structure of the pixel circuit C varies, which may be determined according to actual needs. For example, the pixel circuit C may be of a structure with "2T1C," "6T1C," "7T1C," "6T2C," or "7T2C". Here, "T" represents a transistor, a number before "T" represents the number of transistors, "C" represents a storage capacitor, and a number before "C" represents the number of storage capacitors.

For example, the plurality of pixel circuits C are arranged in an array. The plurality of pixel circuits C may be arranged in multiple lines along a first direction X and in multiple lines along a second direction Y The first direction X and the second direction Y are, for example, perpendicular to each other.

For example, the light-emitting device layer 3 includes a plurality of light-emitting devices P.

Optionally, the light-emitting device P may be referred to as an organic light-emitting diode (OLED).

For example, the light-emitting device P may include an anode, a light-emitting layer and a cathode that are stacked.

For example, the light-emitting device P further includes: at least one of a hole injection layer, a hole transport layer, and an electron blocking layer that are located between the anode and the light-emitting layer, and at least one of an electron injection layer, an electron transport layer, and a hole blocking layer that are located between the cathode and the light-emitting layer. In this way, the luminous efficiency of the light-emitting device P can be improved.

For example, the structure of the anode may be a stacked composite structure composed of transparent conductive oxide/metal/transparent conductive oxide sequentially stacked. The transparent conductive oxide material is, for example, any one of Indium tin oxide (ITO) and Indium zinc oxide (IZO), and the metal material is, for example, any one of gold (Au), silver (Ag), nickel (Ni) and platinum (Pt).

For example, the cathode may be made of any one of aluminum (Al), silver (Ag), and magnesium (Mg), or may be made of any one of magnesium-silver alloy and aluminum-lithium alloy.

The electrical connection relationship between the light-emitting device P and the pixel circuit C is not limited in the present disclosure, which can be determined according to actual needs.

For example, multiple pixel circuits C are electrically connected to one light-emitting device P. The multiple pixel circuits C can provide driving signals to the corresponding light-emitting device P to drive the corresponding light-emitting device P to emit light.

As another example, a single pixel circuit C is electrically connected to multiple light-emitting devices P. The single pixel circuit C can provide a driving signal to the corresponding multiple light-emitting devices P to drive the corresponding multiple light-emitting devices P to emit light.

As another example, a single pixel circuit C is electrically connected to a single light-emitting device P. The single pixel circuit C can provide a driving signal to the corresponding single light-emitting device P to drive the corresponding single light-emitting device P to emit light.

In the present disclosure, the structure of the display substrate 100 will be schematically described below by taking an example in which a single pixel circuit C is electrically connected to a single light-emitting device P.

In some examples, as shown in FIGS. 2 and 3, the plurality of pixel circuits C include a plurality of first pixel circuits C1 and a plurality of second pixel circuits C2. For example, the first pixel circuit C1 and the second pixel circuit C2 have the same structure.

For example, in the first direction X, in the same row of pixel circuits C, at least one second pixel circuit C2 is disposed between two adjacent first pixel circuits C1.

For example, the number of second pixel circuit(s) C2 located between two adjacent first pixel circuits C1 is 1, 2, 4, 7, 10, etc.

It should be noted that the number of second pixel circuit(s) C2 disposed between any two adjacent first pixel circuits C1 may be the same or different, which may be determined according to actual needs.

For example, the number of second pixel circuit(s) C2 disposed between any two adjacent first pixel circuits C1 is the same.

For example, as shown in FIG. 2, there is one second pixel circuit C2 disposed between any two adjacent first pixel circuits C1.

As another example, as shown in FIG. 3, there are two second pixel circuits C2 disposed between any two adjacent first pixel circuits C1.

In some examples, as shown in FIGS. 2 and 3, the plurality of light-emitting devices P include a plurality of first light-emitting devices P1 and a plurality of second light-emitting devices P2. For example, the first light-emitting device P1 and the second light-emitting device P2 have the same structure.

For example, the plurality of first pixel circuits C1 are respectively electrically connected to the plurality of first light-emitting devices P1, and respectively provide driving signals to the plurality of first light-emitting devices P1, so as to drive the plurality of first light-emitting devices P1 to emit light. The plurality of second pixel circuits C2 may be respectively electrically connected to the plurality of second light-emitting devices P2, and respectively provide driving signals to the plurality of second light-emitting devices P2, so as to drive the plurality of second light-emitting devices P2 to emit light.

For example, the plurality of first light-emitting devices P1 are located in the first display region A, and the plurality of second light-emitting devices P2 are located in the second display region B. In this way, both portions of the display substrate 100 located in the first display region A and the second display region B can perform display, so that the display substrate 100 has a large display area.

For example, the first pixel circuits C1 electrically connected to the first light-emitting devices P1 and the second pixel circuits C2 electrically connected to the second light-emitting devices P2 are all located in the second display region B.

It can be understood that the material of the pixel circuit C includes a metal material which has a low light transmittance and high light blocking effect. In the present disclosure, the first pixel circuits C1 electrically connected to the first light-emitting devices P1 are disposed in the second display region B; when external light is incident on the portion of the display substrate 100 located in the first display region A, the first pixel circuits C1 can be prevented from blocking the external light, so that the external light can exit through a gap between any two adjacent first light-emitting devices P1; therefore, the portion of the display substrate 100 located in the first display region A has a high light transmittance.

In this way, the display substrate 100 is applied to a display module, an image acquisition device is provided on a non-light-exiting side of the display substrate 100, and the image acquisition device is disposed in the first display region A; in this case, it can be ensured that the external light can pass through the portion of the display substrate 100 located in the first display region A to be incident on the image acquisition device and be acquired by the image acquisition device; therefore, the image acquisition device can work normally.

In some examples, as shown in FIG. 6, the display substrate 100 further includes a plurality of wires L.

For example, the first pixel circuits C1 and the first light-emitting devices P1 are electrically connected through the wires L.

In one implementation manner, the first pixel circuits C1 and the first light-emitting devices P1 are electrically connected in a "near-to-near and far-to-far" manner. That is, among the plurality of first light-emitting devices P1 located in the same row, the first light-emitting device P1 closest to the boundary of the first display region A is electrically connected to the first pixel circuit C1 closest to the boundary of the first display region A, and correspondingly, the wire connecting the first light-emitting device P1 and the first pixel circuit C1 has the shortest length; the first light-emitting device P1 that is second-closest to the boundary of the first display region A is electrically connected to the first pixel circuit C1 that is second-closest to the boundary of the first display region A, and correspondingly, the wire connecting the first light-emitting device P1 and the first pixel circuit C1 has the second shortest length; ...; the first light-emitting device P1 that is second-farthest to the boundary of the first display region A is electrically connected to the first pixel circuit C1 that is second-farthest to the boundary of the first display region A, and correspondingly, the wire connecting the first light-emitting device P1 and the first pixel circuit C1 has the second longest length; and the first light-emitting device P1 that is farthest to the boundary of the first display region A is electrically connected to the first pixel circuit C1 that is farthest to the boundary of the first display region A, and correspondingly, the wire connecting the first light-emitting device P1 and the first pixel circuit C1 has the longest length.

The lengths of the longest wire and the shortest wire differ by a large multiple (for example, differ by 65 times at least). In this way, for the longest wire and the shortest wire, overlapping areas of them and other signal lines (such as a data line, a gate line, a voltage signal line, etc.) differ by a large multiple, and parasitic capacitances created between them and other signal lines differ by a large multiple. Therefore, the difference in loss generated during the process of transmitting driving signals output by different first pixel circuits C1 in corresponding wires is large, resulting in a large difference in the driving signals transmitted to different first light-emitting devices P1, which in turn causes a large difference in brightness of light emitted by different light-emitting devices P1. As a result, the display images are uneven.

In another implementation manner, an external optical compensation (demura) method is generally used to compensate for the brightness difference between different first light-emitting devices. A key step of the demura method is to use the demura algorithm to process data of brightness of light emitted by different first light-emitting devices P1, thus generating compensation data required for the different first light-emitting devices P1 to compensate for the difference in the brightness of the light emitted by the different first light-emitting devices P1. As a result, the non-uniformity of the display image is ameliorated.

Since in the above one implementation manner, light emitted by different first light-emitting devices P1 has large brightness difference, and correspondingly, it is difficult to compensate for the brightness difference between different first light-emitting devices P1 using the demura algorithm, so that the compensation accuracy of the demura algorithm is reduced.

In light of this, in the present disclosure, the plurality of first light-emitting devices P1, the plurality of first pixel circuits C1, and the plurality of wires L are divided.

In some examples, as shown in FIG. 6, in the present disclosure, multiple first light-emitting devices P1 that are sequentially arranged in the first direction X among the plurality of first light-emitting devices P1 are divided into N first light-emitting device groups 10, and the N first light-emitting device groups 10 are sequentially arranged in the first direction. Each first light-emitting device group 10 includes M first light-emitting devices P1 sequentially arranged along the first direction X. In a positive direction of the first direction X, the N first light-emitting device groups are respectively 1st first light-emitting device group 10 to Nth first light-emitting device group 10, and the M first light-emitting devices are respectively 1st first light-emitting device to Mth first light-emitting device. N is greater than or equal to 2 (N ≥ 2), M is greater than or equal to 2 (M ≥ 2), and N and M are both integers.

It should be noted that, considering FIG. 1 as an example, the positive direction of the first direction X may be a direction pointing from the left side of the display substrate 100 to the right side of the display substrate 100 along the first direction X, or a direction pointing from the right side of the display substrate 100 to the left side of the display substrate 100 along the first direction X.

For example, N is 2, 3, 4, 5, 6, etc.

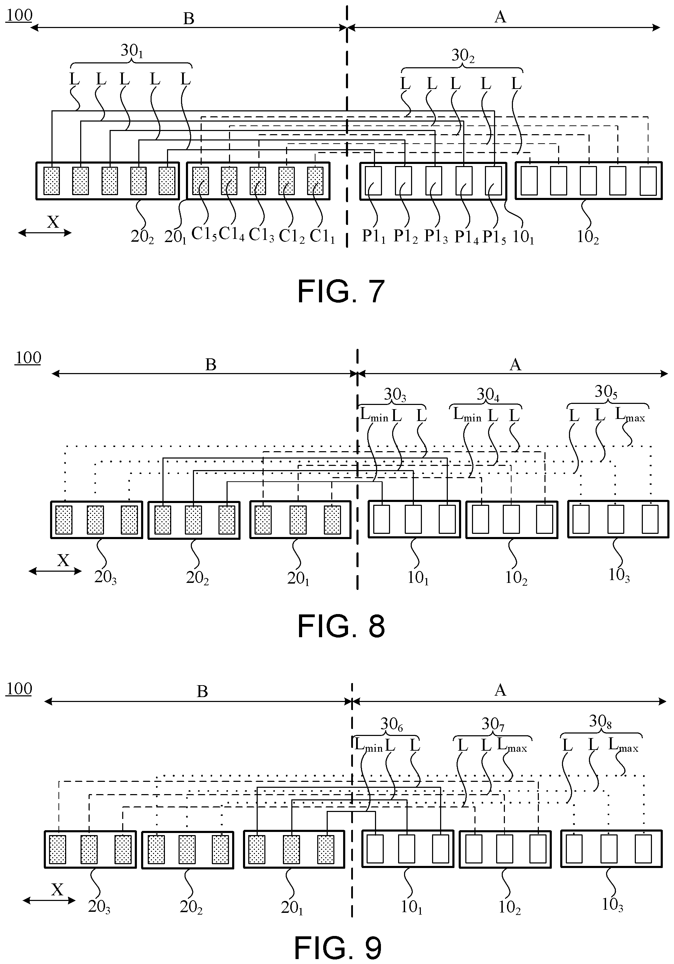

For example, as shown in FIG. 7, when N is equal to 2 (N = 2), the display substrate 100 includes two first light-emitting device groups 10. In the positive direction of the first direction X, the two first light-emitting device groups 10 are respectively the 1st first light-emitting device group 10₁ and the 2nd first light-emitting device group 10₂.

For example, as shown in FIGS. 8 to 12, when N = 3, the display substrate 100 includes three first light-emitting device groups 10. In the positive direction of the first direction X, the three first light-emitting device groups 10 are respectively the 1st first light-emitting device group 10₁, the 2nd first light-emitting device group 10₂, and the 3rd first light-emitting device group 10s.

For example, M is 5, 10, 20, 50, 100, etc.

For example, as shown in FIG. 7, when M = 5, the first light-emitting device group 10 includes five first light-emitting devices P1. In the positive direction of the first direction X, the five first light-emitting devices P1 are respectively the 1st first light-emitting device P1₁, the 2nd first light-emitting device P1₂, the 3rd first light-emitting device P1₃, the 4th first light-emitting device P1₄, and the 5th first light-emitting device P1s.

In some examples, as shown in FIG. 6, in the present disclosure, multiple first pixel circuits C1 that are sequentially arranged in the first direction X among the plurality of first pixel circuits C1 are divided into N first pixel circuit groups 20, and the N first pixel circuit groups 20 are arranged sequentially in the first direction X. The N first pixel circuit groups 20 are located on the same side of the N first light-emitting device groups 10. Each first pixel circuit group 20 includes M first pixel circuits C1 that are sequentially arranged in the first direction X. In a negative direction of the first direction X, the N first pixel circuit groups 20 are respectively 1st first pixel circuit group 20 to Nth first pixel circuit group 20, and the M first pixel circuits are respectively 1st first pixel circuit C1 to Mth first pixel circuit C1.

It will be noted that the positive direction of the first direction X and the negative direction of the first direction X are opposite. Considering FIG. 1 as an example, when the positive direction of the first direction X is the direction pointing from the left side of the display substrate 100 to the right side of the display substrate 100 along the first direction X, the negative direction of the first direction X is a direction pointing from the right side of the display substrate 100 to the left side of the display substrate 100 along the first direction X. When the positive direction of the first direction X is the direction pointing from the right side of the display substrate 100 to the left side of the display substrate 100 along the first direction X, the negative direction of the first direction X is a direction pointing from the left side of the display substrate 100 to the right side of the display substrate 100 along the first direction X.

For example, N is 2, 3, 4, 5, 6, etc.

For example, as shown in FIG. 7, when N = 2, the display substrate 100 includes two first pixel circuit groups 20. In the negative direction of the first direction X, the two first pixel circuit groups 20 are respectively the 1st first pixel circuit group 20₁ and the 2nd first pixel circuit group 20₂.

For example, as shown in FIGS. 8 to 12, when N = 3, the display substrate 100 includes three first pixel circuit groups 20. In the negative direction of the first direction X, the three first pixel circuit groups 20 are respectively the 1st first pixel circuit group 20₁, the 2nd first pixel circuit group 20₂ and the 3rd first pixel circuit group 20s.

For example, M is 5, 10, 20, 50, 100, etc.

For example, as shown in FIG. 7, when M = 5, the first pixel circuit group 20 includes five first pixel circuits C1. In the negative direction of the first direction X, the five first pixel circuits C1 are respectively the 1st first pixel circuit C1₁, the 2nd first pixel circuit C1₂, the 3rd first pixel circuit C1s, the 4th first pixel circuit C1₄, and the 5th first pixel circuit C1s.

In some examples, as shown in FIG. 4, in the present disclosure, multiple wires L connecting one first light-emitting device group 10 and one first pixel circuit group 20 among the plurality of wires L are divided into one wire group 30. The wire group 30 includes M wires L.

For example, in the first light-emitting device group 10, the first pixel circuit group 20 and the wire group 30 that are connected, the number of first light-emitting devices P1, the number of first pixel circuits C1 and the number of wires L are the same.

It should be noted that the above-mentioned M and N generally refer to more than one, and do not limit the number of first light-emitting devices P1 included in each first light-emitting device group 10 to be the same, the number of first pixel circuits C1 included in each first pixel circuit group 20 to be the same, and the number of wires L included in each wire group 30 to be the same.

For example, the M wires L included in the wire group 30 are arranged in parallel, which may avoid that the M wires intersect to cause the problem of short circuit.

For example, an ith first light-emitting device P1 in the first light-emitting device group 10 is electrically connected to an ith first pixel circuit C1 in the first pixel circuit group 20 through an ith wire L, where i is in a range of 1 to M inclusive.

For example, as shown in FIG. 7, the number M of first light-emitting devices P1 included in a first light-emitting device group 10 is 5, the number of first pixel circuits C2 included in a first pixel circuit group 20 electrically connected to the first light-emitting device group 10 is 5, and the number of wire groups 30 electrically connected to the first light-emitting device group 10 is 5. In this case, a 1st first light-emitting device P1₁ is electrically connected to a 1st first pixel circuit C1₁ through a 1st wire L; a 2nd first light-emitting device P1₂ is electrically connected to a 2nd first pixel circuit C1₂ through a 2nd wire L; a 3rd first light-emitting device P1₃ is electrically connected to a 3rd first pixel circuit C1s through a 3rd wire L; a 4th first light-emitting device P1₄ is electrically connected to a 4th first pixel circuit C1₄ through a 4th wire L; and a 5th first light-emitting device P1₅ is electrically connected to a 5th first pixel circuit C1s through a 5th wire L.

In this way, as for the first light-emitting device P1 and the first pixel circuit C1 that are electrically connected to the same wire L, a sequence number of the first light-emitting device P1 in the first light-emitting device group 10 and a sequence number of the first pixel circuit C1 in the first pixel circuit group 20 are the same. That is, among the first light-emitting device groups 10 and the first pixel circuit groups 20 that are electrically connected, the first light-emitting device P1 closest to the boundary of the first display region A is electrically connected to the first pixel circuit C1 closest to the boundary of the first display region A; the first light-emitting device P1 second-closest to the boundary of the first display region A is electrically connected to the first pixel circuit C1 second-closest to the boundary of the first display region A; ...; the first light-emitting device P1 second-farthest from the boundary of the first display region A is electrically connected to the first pixel circuit C1 second-farthest from the boundary of the first display region A; and the first light-emitting device P1 farthest from the boundary of the first display region A is electrically connected to the first pixel circuit C1 farthest from the boundary of the first display region A.

In this way, in the same wire group 30, the lengths of the plurality of wires L change with high regularity, overlapping areas of the plurality of wires L and other signal lines have high regularity, and parasitic capacitances created between the plurality of wires L and other signal lines have high regularity.

Correspondingly, when the demura method is applied to the display substrate 100, the computational difficulty of the demura algorithm can be reduced, thereby improving the compensation accuracy of the demura algorithm.

It should be noted that the first light-emitting device group 10 and the first pixel circuit group 20 electrically connected thereto can be located in the same row or in different rows, which can be determined according to actual needs.

For example, as shown in FIGS. 6 to 12, the first light-emitting device group 10 and the first pixel circuit group 20 electrically connected thereto are arranged in the same row.

For example, a main body portion of each wire L in the wire group 30 extends in the first direction X. The main body portion of the wire L refers to the longest portion of the wire extending in the same direction.

For example, the first light-emitting device group 10 and the first pixel circuit group 20 electrically connected thereto are located in different rows.

For example, each wire L in the wire group 30 extends in a direction pointing from the first light-emitting device group 10 to the first pixel circuit group 20. Optionally, an angle between the extension direction of the wire and the first direction is 45°, etc.

In some examples, as shown in FIGS. 7 to 12, the 1st first light-emitting device group 10₁ is electrically connected to a first pixel circuit group 20 other than the 1st first pixel circuit group 20₁. And/or, the Nth first light-emitting device group 10_{N} is electrically connected to a first pixel circuit group 20 other than the Nth first pixel circuit group 20_{N}.

The electrical connection manner of the first light-emitting device group 10 and the first pixel circuit group 20 is schematically described below with reference to FIGS. 7 to 12.

For example, the 1st first light-emitting device group 10₁ is electrically connected to a first pixel circuit group 20 other than the 1st first pixel circuit group 20₁.

That is to say, the 1st first light-emitting device group 10₁ may be electrically connected to any one of the 2nd to Nth first pixel circuit groups 20. The 1st first pixel circuit group 20 may be electrically connected to any one of the 2nd to Nth first light-emitting device groups 10.

For example, as shown in FIG. 7, when N = 2, the 1st first light-emitting device group 10₁ is electrically connected to the 2nd first pixel circuit group 20₂.

For example, as shown in FIGS. 8 and 10 to 12, when N = 3, the 1st first light-emitting device group 10₁ is electrically connected to the 2nd first pixel circuit group 20₂. Alternatively, the 1st first light-emitting device group 10₁ is electrically connected to the 3rd first pixel circuit group 20s.

For example, as shown in FIGS. 8 and 10 to 12, when N = 3, the 1st first pixel circuit group 20₁ may be electrically connected to the 2nd first light-emitting device group 10₂. Alternatively, the 1st first pixel circuit group 20₁ may be electrically connected to the 3rd first light-emitting device group 10s.

It can be understood that a wire L with the shortest length in each wire group 30 is a wire L that connects a 1st light-emitting device P1₁ in a certain first light-emitting device group 10 and a 1st first pixel circuit C1₁ in a certain first pixel circuit group 20. Furthermore, a case where the certain first light-emitting device group 10 is the 1st first light-emitting device group 10₁ and a case where the certain first pixel circuit group 20 is the 1st first pixel circuit group 20₁ do not appear at the same time.

In this case, among the plurality of wires L included in the display substrate 100, at least one first pixel circuit group 20 and/or at least one first light-emitting device group 10 exists between a first light-emitting device P1 and a first pixel circuit C1 that are electrically connected to the shortest wire Lₘᵢₙ. That is, multiple first pixel circuits C1 and/or multiple first light-emitting devices P1 exist between the first light-emitting device P1 and the first pixel circuit C1 that are electrically connected to the shortest wire Lₘᵢₙ. Compared with the above one implementation manner, the length of the shortest wire Lₘᵢₙ in this example is greater than the length of the shortest wire in the above one implementation manner.

It should be noted that the Mth first light-emitting device P1 in the Nth first light-emitting device group 10_{N} is a first light-emitting device P1 farthest from the boundary of the first display region A, and the Mth first pixel circuit C1 in the Nth first pixel circuit group 20_{N} is a first pixel circuit C1 farthest from the boundary of the first display region A. In the case where the Nth first light-emitting device group 10_{N} is electrically connected to the Nth first pixel circuit group 20_{N}, a wire L connecting the Mth first light-emitting device P1 in the Nth first light-emitting device group 10_{N} and the Mth first pixel circuit C1 in the Nth first pixel circuit group 20_{N} is the longest wire Lₘₐₓ in all wire groups 30. The length of the longest wire Lₘₐₓ is substantially equal to the length of the longest wire in the above one implementation manner. In this example, the Nth first light-emitting device group 10_{N} may be electrically connected to a first pixel circuit group 20 other than the Nth first pixel circuit group 20_{N}, or the Nth first pixel circuit group 20_{N} may be electrically connected to a first light-emitting device group 10 other than the Nth first light-emitting device group 10_{N}. Therefore, in the present disclosure, the length of the longest wire Lₘₐₓ is less than or equal to the length of the longest wire in the above one implementation manner.

That is to say, in this example, the length of the shortest wire Lₘᵢₙ is greater than the length of the shortest wire in the one implementation manner, and the length of the longest wire Lₘₐₓ is less than or equal to the length of longest wire in the one implementation manner. Therefore, the difference between the length of the shortest wire Lₘᵢₙ and the length of the longest wire Lₘₐₓ is effectively reduced.

For example, the Nth first light-emitting device group 10_{N} is electrically connected to a first pixel circuit group 20 other than the Nth first pixel circuit group 20_{N}.

That is to say, the Nth first light-emitting device group 10_{N} may be electrically connected to any one of the 1st to (N-1)th first pixel circuit groups 20. The Nth first pixel circuit group 20_{N} may be electrically connected to any one of the 1st to (N-1)th first light-emitting device groups 10.

For example, as shown in FIG. 7, when N = 2, the 2nd first light-emitting device group 10₂ is electrically connected to the 1st first pixel circuit group 20₁.

For example, as shown in FIGS. 9 to 12, when N = 3, the 3rd first light-emitting device group 10s is electrically connected to the 1st first pixel circuit group 20₁. Alternatively, the 3rd first light-emitting device group 10s is electrically connected to the 2nd first pixel circuit group 20₂.

For example, as shown in FIGS. 9 to 12, when N = 3, the 3rd first pixel circuit group 20₃ is electrically connected to the 1st first light-emitting device group 10₁. Alternatively, the 3rd first pixel circuit group 20₃ is electrically connected to the 2nd first light-emitting device group 10₂.

It can be understood that the longest wire L in each wire group 30 is a wire that connects a 1st light-emitting device P1₁ in a certain first light-emitting device group 10 and a 1st first pixel circuit C1₁ in a certain first pixel circuit group 20. Moreover, a case where the certain first light-emitting device group 10 is the Nth first light-emitting device group 10_{N} and a case where the certain first pixel circuit group 20 is the Nth first pixel circuit group 20_{N} do not appear at the same time.

In this case, among the plurality of wires L included in the display substrate 100, at least (M-1) first pixel circuits C1 exist between a first pixel circuit C1 that is electrically connected to the longest wire Lₘₐₓ and a first pixel circuit C1 that is farthest from the boundary of the first display region A, or at least (M-1) first light-emitting devices P1 exist between a first light-emitting device P1 that is electrically connected to the longest wire Lₘₐₓ and a first light-emitting device P1 that is farthest from the boundary of the first display region A. Compared with the above one implementation manner, the length of the longest wire Lₘₐₓ in this example is less than the length of the longest wire in the above one implementation manner.

It should be noted that the 1st first light-emitting device P1₁ in the 1st first light-emitting device group 10₁ is the first light-emitting device P1 closest to the boundary of the first display region A, and the 1st first pixel circuit C1₁ in the 1st first pixel circuit group 20₁ is the first pixel circuit C1 closest to the boundary of the first display region A. When the 1st first light-emitting device group 10₁ is electrically connected to the 1st first pixel circuit group 20₁, the wire L connecting the 1st first light-emitting device P1₁ in the 1st first light-emitting device group 10₁ and the 1st first pixel circuit C1₁ in the 1st first pixel circuit group 20₁ is the wire Lₘᵢₙ with the shortest length in all the wire groups 30. The length of the shortest wire Lₘᵢₙ is substantially equal to the length of the shortest wire in the above one implementation manner. In this example, the 1st first light-emitting device group 10_{N} may be electrically connected to a first pixel circuit group 20 other than the 1st first pixel circuit group 20₁, or the 1st first pixel circuit group 20₁ may be electrically connected to a first light-emitting device group 10 other than the 1st first light-emitting device group 10₁. Therefore, in the present disclosure, the length of the shortest wire Lₘᵢₙ is greater than or equal to the length of the shortest wire in the above one implementation manner.

That is to say, in this example, the length of the longest wire Lₘₐₓ is less than the length of the longest wire in the above one implementation manner, and the length of the shortest wire Lₘᵢₙ is greater than or equal to the length of the shortest wire in the above one implementation manner. Therefore, the difference between the length of the shortest wire Lₘᵢₙ and the length of the longest wire Lₘₐₓ is effectively reduced.

For example, the 1st first light-emitting device group 10₁ is electrically connected to a first pixel circuit group 20 other than the 1st first pixel circuit group 20₁. Meanwhile, the Nth first light-emitting device group 10_{N} is electrically connected to a first pixel circuit group 20 other than the Nth first pixel circuit group 20_{N}.

That is to say, the 1st first light-emitting device group 10₁ may be electrically connected to any one of the 2nd to (N-1)th first pixel circuit groups, and the Nth first light-emitting device group 10_{N} may be electrically connected to any one of the 1st to (N-1)th first pixel circuit group 20.

For example, as shown in FIG. 7, when N = 2, the 1st first light-emitting device group 10₁ is electrically connected to the 2nd first pixel circuit group 20₂, and the 2nd first light-emitting device group 10₂ is electrically connected to the 1st first pixel circuit group 20₁.

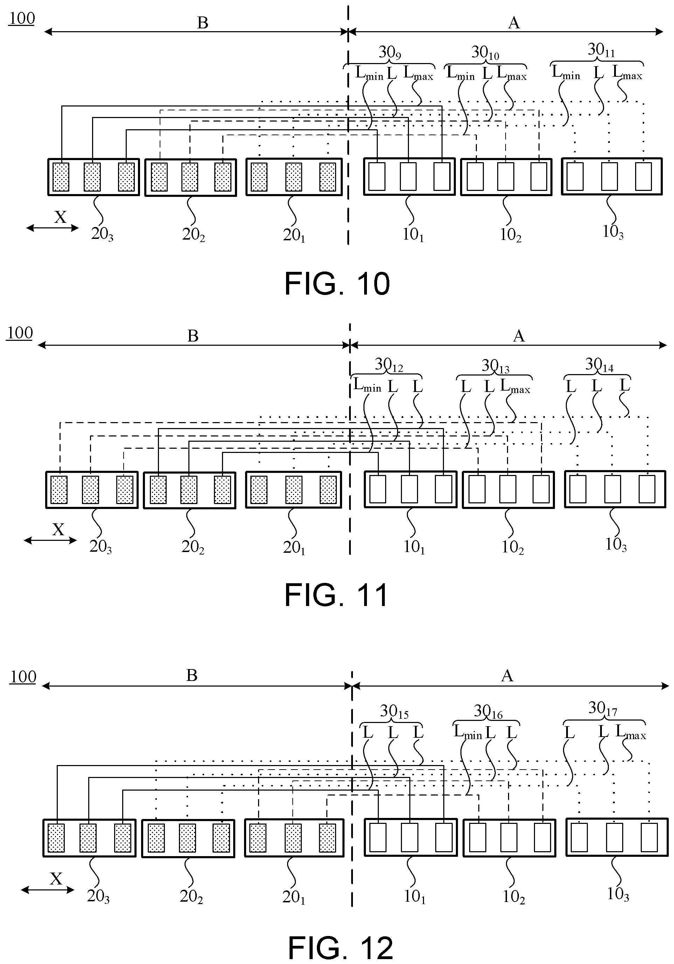

For example, as shown in FIGS. 10 to 12, when N = 3, the 1st first light-emitting device group 10₁ is electrically connected to the 2nd first pixel circuit group 20₂ or the 3rd first pixel circuit group 20s; and the 3rd first light-emitting device group 10s is electrically connected to the 1st first pixel circuit group 20₁ or the 2nd first pixel circuit group 20₂.

In this way, among the plurality of wires L included in the display substrate 100, at least one first pixel circuit group 20 and/or at least one first light-emitting device group 10 exist between the first light-emitting device P1 and the first pixel circuit C1 that are electrically connected to the shortest wire Lₘᵢₙ. Meanwhile, at least (M-1) first pixel circuits C1 exist between the first pixel circuit C1 electrically connected to the longest wire Lₘₐₓ and the first pixel circuit C1 farthest from the boundary of the first display region A. Alternatively, at least (M-1) first light-emitting devices P1 exist between the first light-emitting device P1 electrically connected to the longest wire Lₘₐₓ and the first light-emitting device P1 farthest from the boundary of the first display region A.

It means that in this example, the length of the shortest wire Lₘᵢₙ is greater than the length of the shortest wire in the above one implementation manner, and the length of the longest wire Lₘₐₓ is less than the length of the longest wire in the above one implementation manner, thereby further reducing the difference between the length of the shortest wire Lₘᵢₙ and the length of the longest wire Lₘₐₓ.

The corresponding relationship between the N first light-emitting device groups 10 and the N first pixel circuit groups 20 and the conditions of the shortest wire Lₘᵢₙ and the longest wire Lₘₐₓ among the plurality of wires L are schematically described below by taking an example in which the number N of the first light-emitting device groups 10 is 2 and the number N of the first light-emitting device groups 10 is 3.

For example, as shown in FIG. 7, when N = 2, the 1st first light-emitting device group 10₁ is electrically connected to the 2nd first pixel circuit group 20₂ through the wire group 30₁, and the 2nd first light-emitting device group 10₂ is electrically connected to the 1st first pixel circuit group 20₁ through the wire group 30₂.

In an aspect, the 1st first pixel circuit group 20₁ exists between the 1st first light-emitting device group 10₁ and the 2nd first pixel circuit group 20₂, and the 1st first light-emitting device group 10₁ exists between the 2nd first light-emitting device group 10₂ and the 1st first pixel circuit group 20₁.

Therefore, the 1st first pixel circuit group 20₁ (that is, at least M first pixel circuits C1) exists between a first light-emitting device P1 and a first pixel circuit C1 that are electrically connected to the shortest wire in a plurality of wires L included in the wire group 30₁. The 1st first light-emitting device group 10 (that is, M first light-emitting devices P1) exists between a first light-emitting device P1 and a first pixel circuit C1 that are electrically connected to the shortest wire in a plurality of wires L included in the wire group 30₂. Therefore, in this example, the length of the shortest wire Lₘᵢₙ in the wires L included in each wire group 30 is greater than the length of the shortest wire in the above one implementation manner.

In another aspect, a first pixel circuit C1 electrically connected to the longest wire in the plurality of wires L included in the wire group 30₁ is the first pixel circuit C1 farthest from the boundary of the first display region A. A first light-emitting device P1 electrically connected to the longest wire in the plurality of wires L included in the wire group 30₁ belongs to the 1st first light-emitting device group 10₁, and (M-1) first light-emitting devices P1 exist between the first light-emitting device P1 electrically connected to the longest wire in the plurality of wires L included in the wire group 30₁ and the first light-emitting device P1 farthest from the boundary of the first display region A. Therefore, the length of the longest wire in the wire group 30₁ is less than the length of the longest wire in the above one implementation manner.

A first light-emitting device P1 electrically connected to the longest wire in a plurality of wires L included in the wire group 30₂ is the first light-emitting device P1 farthest from the boundary of the first display region A. A first pixel circuit C1 electrically connected to the longest wire in the plurality of wires L included in the wire group 30₂ belongs to the 1st first pixel circuit group, and (M-1) first pixel circuits C1 exist between the first pixel circuit C1 electrically connected to the longest wire in the plurality of wires L included in the wire group 30₂ and the first pixel circuit C1 farthest from the boundary of the first display region A. Therefore, the length of the longest wire in the wire group 30₂ is less than the length of the longest wire in the above one implementation manner.

Therefore, in each wire group 30, the length of the longest wire Lₘₐₓ is less than the length of the longest wire in the above one implementation manner, and the length of the shortest wire Lₘᵢₙ is greater than the length of the shortest wire in the above one implementation manner. As a result, compared with the above one implementation manner, in this example, the difference between the length of the longest wire Lₘₐₓ and the length of the longest wire Lₘₐₓ is reduced.

For example, as shown in FIGS. 8 to 12, when N = 3, the electrical connection manners of the first light-emitting device groups 10 and the first pixel circuit groups 20 vary.

For example, as shown in FIG. 8, the 1st first light-emitting device group 10₁ is electrically connected to the 2nd first pixel circuit group 20₂ through the wire group 30s. The 2nd first light-emitting device group 10₂ is electrically connected to the 1st first pixel circuit group 20₁ through the wire group 30₄. The 3rd first light-emitting device group 10s is electrically connected to the 3rd first pixel circuit group 20₃ through the wire group 30s.

A distance between the 3rd first light-emitting device group 10s and the 3rd first pixel circuit group 20₃ is the longest, and the longest wire Lₘₐₓ among the plurality of wires L included in the wire group 30s is the longest wire Lₘₐₓ among a plurality of wires L included in all the wire groups 30. The length of the longest wire Lₘₐₓ is substantially equal to the length of the longest wire in the above one implementation manner.

However, the 1st first pixel circuit group 20₁ exists between the 1st first light-emitting device group 10₁ and the 2nd first pixel circuit group 20₂, and the 1st first light-emitting device group 10₁ exists between the 2nd first light-emitting device group 10₂ and the 1st first pixel circuit group 20₁.

The 1st first pixel circuit group 20 (that is, at least M first pixel circuits C) exists between the first light-emitting device P1 and the first pixel circuit C1 that are electrically connected to the shortest wire among the plurality of wires L included in the wire group 30s. The 1st first light-emitting device group 10 (that is, M first light-emitting devices P1) exists between the first light-emitting device P1 and the first pixel circuit C1 that are electrically connected to the shortest wire among the plurality of wires L included in the wire group 30₄. Therefore, the length of the shortest wire Lₘᵢₙ among the wires L included in each wire group 30 in this example is greater than the length of the shortest wire in the above one implementation manner.

Therefore, compared with the above one implementation manner, the length of the shortest wire Lₘᵢₙ in this example is greater than the length of the shortest wire in the above one implementation manner. As a result, in this example, the difference between the length of the longest wire Lₘₐₓ and the length of the shortest wire Lₘᵢₙ is small.

As another example, as shown in FIG. 9, the 1st first light-emitting device group 10₁ is electrically connected to the 1st first pixel circuit group 20₁ through the wire group 30₆, the 2nd first light-emitting device group 10₂ is electrically connected to the 3rd first pixel circuit group 20₃ through the wire group 30₇, and the 3rd first light-emitting device group 10s is electrically connected to the 2nd first pixel circuit group 20₂ through the wire group 30s.

A distance between the 1st first light-emitting device group 10₁ and the 1st first pixel circuit group 20₁ is the shortest, and the shortest wire Lₘᵢₙ among the plurality of wires L included in the wire group 30₆ is the shortest wire Lₘᵢₙ among the plurality of wires L included in all the wire groups 30. The length of the shortest wire Lₘᵢₙ is substantially equal to the length of the shortest wire in the above one implementation manner.

However, a first pixel circuit C1 electrically connected to the longest wire among the plurality of wires L included in the wire group 30₇ is the first pixel circuit C1 farthest from the boundary of the first display region A; (M-1) first light-emitting devices P1 exist between a first light-emitting device P1 electrically connected to the longest wire among the plurality of wires L included in the wire group 30₇ and the first light-emitting device P1 farthest from the boundary of the first display region A; therefore, the length of the longest wire in the wire group 30₇ is less than the length of the longest wire in the above one implementation manner.

A first light-emitting device P1 electrically connected to the longest wire among the plurality of wires L included in the wire group 30₈ is the first light-emitting device P1 farthest from the boundary of the first display region A; (M-1) first pixel circuits C1 exist between a first pixel circuit C1 electrically connected to the longest wire among the plurality of wires L included in the wire group 30₈ and the first pixel circuit C1 farthest from the boundary of the first display region A; therefore, the length of the longest wire in the wire group 30s is less than the length of the longest wire in the above one implementation manner.

Therefore, compared with the above one implementation manner, the length of the longest wire Lₘₐₓ in this example is less than the length of the longest wire in the above one implementation manner. As a result, in this example, the difference between the length of the longest wire Lₘₐₓ and the length of the shortest wire Lₘᵢₙ is small.

As another example, as shown in FIG. 10, the 1st first light-emitting device group 10₁ is electrically connected to the 3rd first pixel circuit group 20s through the wire group 30₉. The 2nd first light-emitting device group 10₂ is electrically connected to the 2nd first pixel circuit group 20₂ through the wire group 30₁₀. The 3rd first light-emitting device group 10₃ is electrically connected to the 1st first pixel circuit group 20₁ through the wire group 30₁₁.

In this case, two first pixel circuit groups 20 exist between the 1st first light-emitting device group 10₁ and the 3rd first pixel circuit group 20s. One first light-emitting device group 10 and one first pixel circuit group 20 exist between the 2nd first light-emitting device group 10₂ and the 2nd first pixel circuit group 20₂. Two first light-emitting device groups 10 exist between the 3rd first light-emitting device group 10s and the 1st first pixel circuit group 20₁.

As for the analysis of the shortest wire Lₘᵢₙ and the longest wire Lₘₐₓ among all wires L in this example, reference can be made to the analysis process in some of the above examples, and details will not be repeated here.

In this example, the length of the shortest wire Lₘᵢₙ is greater than the length of the shortest wire in the above one implementation manner, and the length of the longest wire Lₘₐₓ is less than the length of the longest wire in the above one implementation manner. Therefore, in the example, the difference between the longest wire Lₘₐₓ and the shortest wire Lₘᵢₙ is small.

As another example, as shown in FIG. 11, the 1st first light-emitting device group 10₁ is electrically connected to the 2nd first pixel circuit group 20₂ through the wire group 30₁₂. The 2nd first light-emitting device group 10₂ is electrically connected to the 3rd first pixel circuit group 20₃ through the wire group 30₁₃. The 3rd first light-emitting device group 10₃ is electrically connected to the 1st first pixel circuit group 20₁ through the wire group 30₁₄.

In this case, one first pixel circuit group 20 exists between the 1st first light-emitting device group 10₁ and the 2nd first pixel circuit group 20₂. Two first pixel circuit groups 20 and one first light-emitting device group 10 exist between the 2nd first light-emitting device group 10₂ and the 3rd first pixel circuit group 20s. Two first light-emitting device groups 10 exist between the 3rd first light-emitting device group 10s and the 1st first pixel circuit group 20₁.

As for the analysis of the shortest wire Lₘᵢₙ and the longest wire Lₘₐₓ among all wires L in this example, reference can be made to the analysis process in some of the above examples, and details will not be repeated here.

In this example, the length of the shortest wire Lₘᵢₙ is greater than the length of the shortest wire in the above one implementation manner, and the length of the longest wire Lₘₐₓ is less than the length of the longest wire in the above one implementation manner. Therefore, the difference between the longest wire Lₘₐₓ and the shortest wire Lₘᵢₙ in the example is small.

As another example, as shown in FIG. 12, the 1st first light-emitting device group 10₁ is electrically connected to the 3rd first pixel circuit group 20₃ through the wire group 30₁₅. The 2nd first light-emitting device group 10₂ is electrically connected to the 1st first pixel circuit group 20₁ through the wire group 30₁₆. The 3rd first light-emitting device group 10s is electrically connected to the 2nd first pixel circuit group 20₂ through the wire group 30₁₇.

In this case, two first pixel circuit groups 20 exist between the 1st first light-emitting device group 10₁ and the 3rd first pixel circuit group 20s. One first light-emitting device group 10 exists between the 2nd first light-emitting device group 10₂ and the 1st first pixel circuit group 20₁. Two first light-emitting device groups 10 and one first pixel circuit group 20 exist between the 3rd first light-emitting device group 10s and the 2nd first pixel circuit group 20₂.

As for the analysis of the shortest wire Lₘᵢₙ and the longest wire Lₘₐₓ among all wires L in this example, reference can be made to the analysis process in some of the above examples, and details will not be repeated here.

In this example, the length of the shortest wire Lₘᵢₙ is greater than the length of the shortest wire in the above one implementation manner, and the length of the longest wire Lₘₐₓ is less than the length of the longest wire in the above one implementation manner. Therefore, the difference between the longest wire Lₘₐₓ and the shortest wire Lₘᵢₙ in the example is small.

Therefore, in the display substrate 100 provided in some embodiments of the present disclosure, the plurality of first light-emitting devices P1 located in the first display region A are divided into N first light-emitting device groups 10, and the plurality of first pixel circuits C1 located in the second display region B are divided into N first pixel circuit groups 20, so that a first light-emitting device group 10 and a first pixel circuit group 20 are electrically connected through a wire group 30.

Since the 1st first light-emitting device group 10₁ is electrically connected to a first pixel circuit group 20 other than the 1st first pixel circuit group 20₁, it may be possible to ensure that at least one first pixel circuit group 20 and/or at least one first light-emitting device group 10 exists between a first light-emitting device P1 and a first pixel circuit C1 that are electrically connected to the shortest wire Lₘᵢₙ among all wires L, and in turn ensure that the length of the shortest wire Lₘᵢₙ is greater than the length of the shortest wire in the above one implementation manner. Therefore, the difference between the length of the longest wire Lₘₐₓ and the length of the shortest wire Lₘᵢₙ is effectively reduced.

Since the Nth first light-emitting device group 10_{N} is electrically connected to a first pixel circuit group 20 other than the Nth first pixel circuit group 20_{N}, it may be possible to ensure that the first pixel circuit C1 electrically connected to the longest wire Lₘₐₓ among all the wires L is the first pixel circuit C1 other than the first pixel circuit C1 farthest from the boundary of the first display region A, and/or the first light-emitting device P1 electrically connected to the longest wire Lₘₐₓ is the first light-emitting device P1 other than the first light-emitting device P1 farthest from the boundary of the first display region A. As a result, it may ensure that the length of the longest wire Lₘₐₓ is less than the length of the longest wire in the above one implementation manner, and the difference between the length of the longest wire Lₘₐₓ and the length of the shortest wire Lₘᵢₙ is effectively reduced.

Since the 1st first light-emitting device group 10₁ is electrically connected to the first pixel circuit group 20 other than the 1st first pixel circuit group 20₁ and the Nth first light-emitting device group 10_{N} is electrically connected to the first pixel circuit group 20 other than the Nth first pixel circuit group 20_{N}, it may be possible to ensure that the length of the longest wire Lₘₐₓ among all the wires L is less than the length of the longest wire in the above one implementation manner, and the length of the shortest wire Lₘᵢₙ among all the wires L is greater than the length of the shortest wire in the above one implementation manner. As a result, the difference between the length of the longest wire Lₘₐₓ and the length of the shortest wire Lₘᵢₙ is effectively reduced.

Therefore, compared with the above one implementation manner, in the embodiments of the present disclosure, among all the wires L included in the display substrate 100, the difference between the length of the shortest wire Lₘᵢₙ and the length of the longest wire Lₘₐₓ is small. In this way, the difference between the parasitic capacitance created between the shortest wire Lₘᵢₙ and other signal line(s) and the parasitic capacitance created between the longest wire Lₘₐₓ and other signal line(s) is small. Correspondingly, the difference between the parasitic capacitances created between different wires L and other signal lines will be small. Therefore, the difference of loss generated in the process of transmitting driving signals generated by different first pixel circuits C1 in different wires L is small, which may avoid a large difference in driving signals transmitted to different first light-emitting devices P1. Correspondingly, the difference in brightness of light emitted by different first light-emitting devices P1 may be small, which avoids the phenomenon of non-uniform display images. In addition, when the demura method is applied to the display substrate 100, since the difference in brightness of light emitted by different first light-emitting devices P1 is small, the computational complexity of the demura algorithm may be reduced, which may reduce the compensation difficulty of the demura algorithm and in turn improve the compensation accuracy of the demura algorithm.

In some embodiments, the number of first pixel circuits C1 included in each of different first pixel circuit groups 20 may be the same or different, and the number of first light-emitting devices P1 included in each of different first light-emitting device groups 10 may be the same or different, which can be determined according to actual needs.

For example, as shown in FIGS. 7 to 12, the number of first pixel circuits C1 included in each first pixel circuit group 20 is the same, and the number of first light-emitting devices P1 included in each first light-emitting device group 10 is the same.

In this way, when the demura method is applied to the display substrate 100 and the demura algorithm compensates for the difference in brightness of first light-emitting devices P1 in different first light-emitting device groups 10, the amount of data of brightness that needs to be processed is the same, thus simplifying the computational complexity of the demura algorithm.

In some embodiments, the display substrate 100 further includes a plurality of wire layers 4 disposed between the pixel circuit layer 2 and the light-emitting device layer 3 and stacked sequentially.

In some examples, a wire group 30 is located in a wire layer 4. In this case, a plurality of wires L located in a wire group 30 are located in the same wire layer 4.

For example, a wire layer 4 may include a plurality of wire groups 30. In this case, a plurality of wires L included in the plurality of wire groups 30 are located in the same wire layer 4.

For example, each wire layer 4 includes at least two wires L.

For example, the material of the plurality of wire layers 4 includes a light-transmissive conductive material.

It can be understood that light-transmissive conductive material has high transmittance. The wire layers 4 are formed by using the light-transmissive conductive material, so that the plurality of wires L located in the wire layers 4 have high transmittance, which prevents the external light passing through the portion of the display substrate 100 located in the first display region A from being blocked. Therefore, it may be possible to ensure that the portion of the display substrate 100 located in the first display region A has a high transmittance.

For example, the light-transmissive conductive material may include at least one of indium tin oxide, indium zinc oxide, and indium gallium zinc oxide.

In some examples, wires L electrically connected to the same first light-emitting device group 10 are located in the same layer.

For example, a plurality of wires in a wire group electrically connected to the 1st first light-emitting device group are arranged in the same layer, a plurality of wires in a wire group electrically connected to the 2nd first light-emitting device group are arranged in the same layer, ..., and a plurality of wires L in a wire group electrically connected to the Nth first light-emitting device group 10_{N} are arranged in the same layer.

For example, when N = 3, the wires L electrically connected to the 1st first light-emitting device group 10₁ are arranged in the same layer; the wires L electrically connected to the 2nd first light-emitting device group 10₂ are arranged in the same layer; and the wires L electrically connected to the 3rd first light-emitting device group 10s are arranged in the same layer.

It will be noted that, the "same layer" mentioned herein refers to a layer structure that is formed by performing, using a same mask, a single patterning process on a film layer for forming specific patterns that is formed by a same film forming process. Depending on the specific patterns, the single patterning process may include several exposure, development or etching processes, and the specific patterns in the formed layer structure may be continuous or discontinuous, and these specific patterns may also be at different heights or have different thicknesses. In this way, a plurality of wires L electrically connected to the same first light-emitting device group 10 may be synchronously formed in one patterning process, which is conducive to simplifying the manufacturing process of the display substrate 100.

It should be noted that wires L electrically connected to a plurality of different first light-emitting device groups 10 may be arranged in various ways.

For example, the wires L electrically connected to the plurality of different first light-emitting device groups 10 are located in different layers. That is, in a thickness direction of the display substrate 100, the wires L electrically connected to different first light-emitting device groups 10 are located in different wire layers 4, thereby avoiding short circuits between the wires L electrically connected to different first light-emitting device groups 10.

For example, among the wires L electrically connected to the plurality of different first light-emitting device groups 10, wires L electrically connected to a part of first light-emitting device groups 10 are located in the same layer, and wires L electrically connected to another part of first light-emitting device groups 10 are located in the same layer, and the two parts of wires L are located in different layers. In this way, the manufacturing process of the display substrate 100 may be simplified, and the problem of short-circuits between the wires L electrically connected to different first light-emitting device groups 10 may be avoided.

In some examples, the number of the plurality of wire layers 4 is the same as the number of the N first light-emitting device groups 10. That is, when the number of first light-emitting device groups 10 is N, the number of wire layers 4 is also N. In this way, it may be possible to reduce the number of required wire layers 4 in the display substrate 100, and in turn simplify the manufacturing process of the display substrate 100 and avoid an increase in the thickness of the display substrate 100.

For example, the number of first light-emitting device groups 10 is 2, and the number of wire layers 4 is also 2.

For example, the number of first light-emitting device groups 10 is 3, and the number of wire layers 4 is also 3.

In some examples, as shown in FIGS. 4 to 5 and 8 to 12, orthographic projections of the M wires in the same wire group 30 on a plane where the display substrate 100 is located do not overlap. Correspondingly, there is a gap between any two adjacent wires L, which may avoid the problem of short circuits between the plurality of wires L located in the same layer.

For example, a width of the gap between any two adjacent wires L in the second direction Y is equal.

In some examples, among the M wires L in the same wire group 30, a length of an ith wire L and a distance between an ith first light-emitting device P1 and an ith first pixel circuit C1 are equal, or differ by a preset length.

For example, a length of a part of wires L among the M wires L is equal to a distance between a first light-emitting device P1 and a first pixel circuit C1 that are electrically connected to the wire L.

For example, a main body portion of the part of wires L extends in the first direction X. The main body portion of the wire L refers to the longest portion of the wire extending in the same direction.

For example, the length of the part of wires L among the M wires L and the distance between the first light-emitting device P1 and the first pixel circuit C1 that are electrically connected to the wire L differ by a preset length ΔL.

For example, an end of the part of wires L is electrically connected to the first light-emitting device P1, and is electrically connected to the first pixel circuit C1 by firstly extending in the second direction Y and toward a side away from the first light-emitting device P1, next extending in the first direction X and from the first display region A toward the second display region B, and then extending in the second direction Y and toward a side close to the first pixel circuit C1 to reach the first pixel circuit C1.

For example, a sequence of a plurality of preset lengths ΔL is in an arithmetic progression. That is, the difference between preset lengths ΔL corresponding to any two adjacent wires L among the part of wires L is equal.

In this way, it is conducive to improving the regularity of change in lengths of the plurality of wires L in the wire group 30, and in turn improving the regularity of parasitic capacitances created in different wires L. Therefore, when the demura method is applied to the display substrate 100, the compensation difficulty of the demura algorithm may be reduced, the compensation accuracy of the demura algorithm is improved, and the difference in brightness of light emitted by the first light-emitting devices P1 is further reduced.

In some examples, a sequence of the lengths of the M wires L in the same wire group 30 is in an arithmetic progression. That is, the difference between the lengths of any two adjacent wires L is equal.

For example, the length of the 1st wire L is a, and the difference between the lengths of any two adjacent wires L is b. In this case, the sequence of the lengths of the M wires L is: a, a+b, a+2b, a+3b, ..., a+(M-2)b, a+(M-1)b.

Since the sequence composed of the lengths of the M wires L is an arithmetic sequence, it may be possible to ensure that the length variation of the M wires L is uniform. In this way, the size variation of overlapping areas of the M wires and other signal lines is regular, and the change in the created parasitic capacitances is also regular. Therefore, it may be possible to ensure that the change in loss generated during the transmission of the driving signals in the M wires is regular, and the difference in brightness of light emitted by different first light-emitting devices P1 may be regular. As a result, when the demura method is applied to the display substrate 100, it is convenient for the demura algorithm to compensate the brightness of the light emitted by different first light-emitting devices P1, and it is conducive to reducing the compensation difficulty of the demura algorithm and improving the compensation accuracy of the demura algorithm.

In some examples, a Pth first light-emitting device group 10 is electrically connected to an (N-P+1)th first pixel circuit group 20 through a corresponding wire group 30, where P is in a range of 1 to N, inclusive. In this case, for a first light-emitting device group 10 and a first pixel circuit group 20 that are electrically connected to each other, a sequence number of the first light-emitting device group 10 and a sequence number of the first pixel circuit group 20 are opposite.

That is, the first light-emitting device group 10 closest to the boundary of the first display region A is electrically connected to the first pixel circuit group 20 farthest from the boundary of the first display region A, the first light-emitting device group 10 second-closest to the boundary of the first display region A is electrically connected to the first pixel circuit group 20 second-farthest from the boundary of the first display region A, ..., and the first light-emitting device group 10 farthest from the boundary of the first display region A is electrically connected to the first pixel circuit group 20 closest to the boundary of the first display region A.

For example, as shown in FIG. 7, N = 2, the 1st first light-emitting device group 10₁ is electrically connected to the 2nd first pixel circuit group 20₂, and the 2nd first light-emitting device group 10₂ is electrically connected to the 1st first pixel circuit group 20₁.

For example, as shown in FIG. 10, N = 3, the 1st first light-emitting device group 10₁ is electrically connected to the 3rd first pixel circuit group 20s, and the 2nd first light-emitting device group 10₂ is electrically connected to the 2nd first pixel circuit group 20₂, and the 3rd first light-emitting device group 10s is electrically connected to the 1st first pixel circuit group 20₁.

Therefore, when the N first light-emitting device groups 10 and the N first pixel circuit groups 20 are electrically connected in the manner in this example, a sum of the number of first light-emitting device groups 10 and/or first pixel circuit groups 20 existing between each pair of first light-emitting device group 10 and first pixel circuit group 20 is the same. As a result, the difference between the lengths of the wires L in different wire groups 30 may be reduced, and the compensation difficulty of the demura algorithm may be further reduced, which is conducive to improving the compensation accuracy of the demura algorithm.

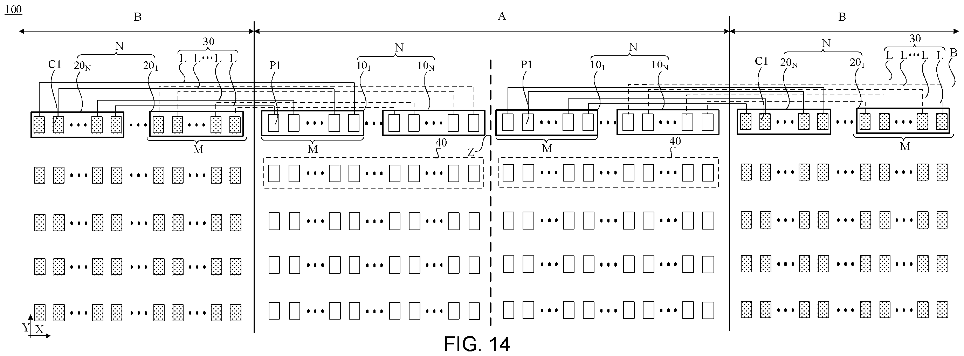

In some examples, as shown in FIG. 14, the display substrate 100 includes two repeating units 40 located in the first display region A and arranged sequentially in the first direction X. Each repeating unit 40 includes N first light-emitting device groups 10. The two repeating units 40 are respectively located on two sides of a reference line Z. The reference line Z is a straight line extending in the second direction Y and passing through the first display region A. First pixel circuit groups 20 electrically connected to the two repeating units 40 are respectively located on two sides of the first display region A in the first direction X. Wire groups 30 electrically connected to the two repeating units 40 are respectively located on the two sides of the reference line Z.

For example, as shown in FIG. 14, the two repeating units 40 are arranged in the same row.

For example, as shown in FIG. 14, one of the two repeating units 40, first pixel circuit groups 20 electrically connected thereto and wire groups 30 electrically connected thereto are located on a side of the reference line Z in the first direction X and a direction pointing from the first display region A to the second display region B. Another one of the two repeating units 40, first pixel circuit groups 20 electrically connected thereto and wire groups 30 electrically connected thereto are located on another side of the reference line Z in the first direction X and a direction pointing from the second display region B to the first display region A.

In this case, in the display substrate 100, wires L may be disposed on two opposite sides of the first display region A, which is conducive to reducing the lengths of the wires L in each wire group 30.

For example, the reference line Z divides the first display region A into two regions.

It should be noted that the number of first light-emitting device groups 10 included in each of the two repeating units 40 may be the same or different.

For example, when the number of first light-emitting device groups 10 included in each of the two repeating units 40 is different, sizes of the two regions are also different.

As another example, when the number of first light-emitting device groups 10 included in each of the two repeating units 40 is the same, the sizes of the two regions are also the same.

For example, the number of first light-emitting device groups 10 included in each of the two repeating units 40 is the same. In this way, the number of required wire group 30 to which each of the two repeating units 40 is connected is also the same. Therefore, when a plurality of wires L in different repeating units 40 are processed by the demura algorithm, the amount of data faced by the demura algorithm is fixed, which may reduce the computational difficulty of the demura algorithm.

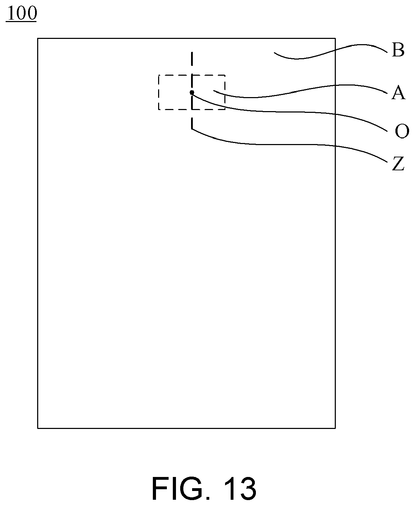

For example, as shown in FIG. 13, the first display region A has a center O, and the reference line Z is a straight line passing through the center O. In this case, the reference line Z divides the first display region A into two symmetrical regions, and the two repeating units 40 are respectively located in the two symmetrical regions.

For example, the structure of N wire groups 30 corresponding to one of the two repeating units 40 and the structure of N wire groups 30 corresponding to another of the two repeating units 40 may be symmetrical about the reference line Z. In this way, the structure of the display substrate 100 may be simplified, and the lengths of a plurality of wires L included in the display substrate 100 may be regular, thereby reducing the compensation difficulty of the demura algorithm and improving the compensation accuracy of the demura algorithm.

For example, a wire group 30 electrically connected to a jth first light-emitting device group 10 in each repeating unit 40 is located in the same layer, where j is in a range of 1 to N, inclusive. That is, in the two repeating units 40, two wire groups 30 electrically connected to two first light-emitting device groups 10 with the same sequence number are arranged in the same layer. In this way, a plurality of wires L in the two wire groups 30 may be formed simultaneously in a single patterning process, which is conducive to simplifying the manufacturing process of the display substrate 100 and reducing the number of wire layers 4.

It should be noted that, when the number of first light-emitting device groups 10 included in each of the two repeating units 40 is the same, the number of wire layers 4 required for arranging the wire groups 30 is the same as the number of first light-emitting device groups 10 included in the repeating unit 40. When the number of first light-emitting device groups 10 included in each of the two repeating units 40 is different, the number of wire layers 4 required for arranging the wire group 30 is from the same as the larger number of first light-emitting devices included in the repeating unit 40.

For example, the number of first light-emitting device groups 10 included in each of the two repeating units 40 is the same, and it is three.

In this case, wire groups 30 electrically connected to 1st first light-emitting device groups 10 in all the repeating units 40 are located in the same layer; wire groups 30 electrically connected to 2nd first light-emitting device groups 10 in all the repeating units 40 are located in the same layer; and wire groups 30 electrically connected to 3rd first light-emitting device groups 10 in all the repeating units 40 are located in the same layer.

In this way, only 3 wire layers are required for arranging 6 wire groups 30, thereby reducing the number of required wire layers 4 and simplifying the manufacturing process of the display substrate 100.

For example, the number of first light-emitting device groups 10 included in each of the two repeating units 40 is different. The number of first light-emitting device groups 10 included in one repeating unit 40 is 4, and the number of first light-emitting device groups 10 included in another repeating unit 40 is 3.

In this case, a wire group 30 electrically connected to the 4th first light-emitting device group 10 included in the repeating unit 40 may be separately located in one wiring layer 4.

In this way, only 4 wire layers are required for arranging 7 wire groups 30, which may reduce the number of required film layers and simplify the manufacturing process of the display substrate 100.

In some examples, as shown in FIG. 14, the display substrate 100 includes: two columns of repeating units located in the first display region A and sequentially arranged in the first direction X, and each column of repeating units includes at least two rows of repeating units 40 sequentially arranged in the second direction Y

It should be noted that the number of first light-emitting device groups 10 included in each of repeating units 40 located in the same column may be the same or different.

For example, the number of first light-emitting device groups 10 included in each of repeating units 40 located in the same column is the same. In this way, the number of wire groups 30 required for each of different repeating units 40 located in the same column is also the same. Therefore, when a plurality of wires L in different repeating units 40 located in the same column are processed by the demura algorithm, the amount of data faced by the demura algorithm is fixed, which may reduce the computational difficulty of the demura algorithm.

For example, first pixel circuit groups 20 electrically connected to the repeating units 40 located in the same column are located on the same side of the first display region A and arranged sequentially in the second direction Y, thereby simplifying the arrangement of the plurality of first pixel circuits C1 included in the display substrate 100 and in turn reducing the manufacturing difficulty of the display substrate 100.

For example, the first pixel circuit groups 20 electrically connected to the repeating units 40 located in the same column are located on a side of these repeating units 40 in the first direction X and the direction pointing from the first display region A to the second display region B.

For example, in the same column of repeating units 40, a wire group 30 electrically connected to a jth first light-emitting device group 10 of each row of repeating units is located in the same layer, where j is in a range of 1 to N, inclusive. That is, in N first light-emitting device groups 10 included in each repeating unit 40, a wire group 30 electrically connected to a first light-emitting device group 10 with the same sequence number is arranged in the same layer. In this way, a plurality of wires L in the wire groups may be formed simultaneously in a single patterning process, which is conducive to simplifying the manufacturing process of the display substrate 100.

Furthermore, the number of required wire groups 30 when there are a plurality of repeating units 40 in each column is the same as the number of required wire groups 30 when there is one repeating unit 40. Since one wire group 30 is located in one wire layer 4, when the number of repeating units 40 increases, the number of required wire layers 4 does not need to increase, and there is no need to increase the number of film layers in the display substrate 100. Therefore, it may be possible to simplify the manufacturing process of the display substrate 100 and avoid increasing the thickness of the display substrate 100.

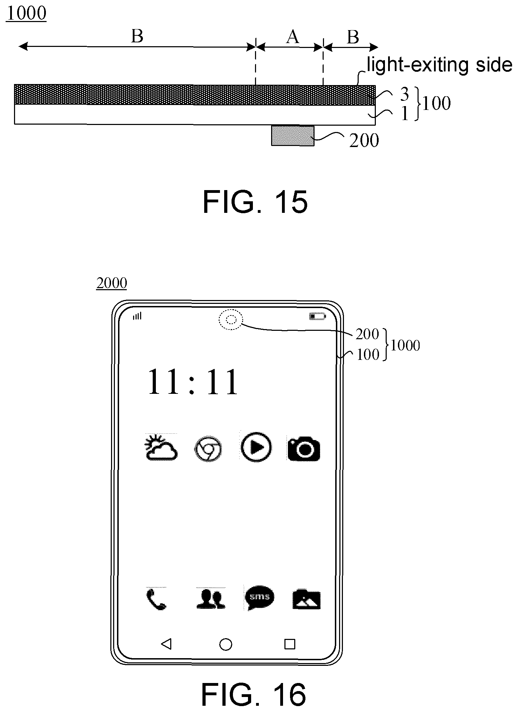

In some embodiments, as shown in FIG. 15, a display module 1000 is provided. The display module 1000 includes: the display substrate 100 as described in the above embodiments, and an image acquisition device 200 disposed on a non-light-exiting side of the display substrate 100 and located in the first display region A of the display substrate 100.

For example, as shown in FIG. 15, when the display substrate 100 includes the substrate 1 and the light-emitting device layer 3 located on a side of the substrate 1, the non-light-exiting side refers to a side of the substrate 1 away from the light-emitting device layer 3 in the display substrate 100. In this case, a side of the light-emitting device layer 3 away from the substrate 1 in the display substrate 100 is a light-exiting side.

For example, the image acquisition device 200 includes a camera or an infrared sensor.

The present disclosure is described by taking an example in which the image acquisition device 200 is a camera.

For example, when the camera is working, since there is no pixel circuit C arranged in the portion of the display substrate 100 located in the first display region A, it may prevent the pixel circuits C from blocking the external light, and the external light may pass through the portion of the display substrate 100 located in the first display region A. In this way, the camera may collect light to realize a camera function.

For example, when the camera is not working, the portion of the display substrate 100 located in the first display region A can also perform display, so that the entire display substrate 100 can display images to achieve the full-screen display.

Therefore, by arranging the camera in the first display region A of the display substrate 100 and on the non-light-exiting side of the display substrate 100, the display substrate 100 may achieve the full-screen display while having a camera function.

The display substrate 100 included in the display module 1000 in the embodiments of the present disclosure has the same structure and beneficial effects as the display substrate 100 provided in the above embodiments, and details will not be repeated here.

In some embodiments, as shown in FIG. 16, a display apparatus 2000 is provided. The display apparatus 2000 includes the display module 1000 as described in the above embodiments.

For example, the display apparatus 2000 may further include a frame, and a circuit board, a display driver integrated circuit (IC) and other electronic components that are disposed in the frame.

For example, the display apparatus 2000 may be a mobile phone, a tablet computer, a notebook computer, a laptop computer, a personal computer, a display, a wearable device, or any other product or component with a display function and an image collection function.

The display module 1000 included in the display apparatus 2000 in the embodiments of the present disclosure has the same structure and beneficial effects as the display module 1000 provided in the above embodiments, and details will not be repeated here.

The foregoing descriptions are merely specific implementations of the present disclosure, but the protection scope of the present disclosure is not limited thereto. Any changes or replacements that a person skilled in the art could conceive of within the technical scope of the present disclosure shall be included in the protection scope of the present disclosure. Therefore, the protection scope of the present disclosure shall be subject to the protection scope of the claims.

## Claims

1. A display substrate having a first display region and a second display region, the second display region surrounding at least a part of the first display region;
the display substrate comprising:
N first light-emitting device groups located in the first display region and arranged sequentially in a first direction, wherein a first light-emitting device group includes M first light-emitting devices arranged sequentially in the first direction; in a positive direction of the first direction, the N first light-emitting device groups are respectively 1st to Nth first light-emitting device groups, and the M first light-emitting devices are respectively 1st to Mth first light-emitting devices; and N is greater than or equal to 2, M is greater than or equal to 2, and N and M are both integers;
N first pixel circuit groups located in the second display region and arranged sequentially in the first direction, wherein the N first pixel circuit groups are located on the same side of the N first light-emitting device groups; a pixel circuit group includes M first pixel circuits arranged sequentially in the first direction; in a negative direction of the first direction, the N first pixel circuit groups are 1st to Nth first pixel circuit groups respectively, and the M first pixel circuits are 1st to Mth first pixel circuits respectively; and
a wire group connecting the first light-emitting device group and the first pixel circuit group, wherein the wire group includes M wires arranged in parallel; an ith first light-emitting device in the first light-emitting device group is electrically connected to an ith first pixel circuit in the first pixel circuit group through an ith wire; and i is in a range of 1 to M, inclusive;
wherein the 1st first light-emitting device group is electrically connected to a first pixel circuit group other than the 1st first pixel circuit group; and/or, the Nth first light-emitting device group is electrically connected to a first pixel circuit group other than the Nth first pixel circuit group.

2. The display substrate according to claim 1, wherein wires electrically connected to the same first light-emitting device group are located in the same layer; and
wires electrically connected to different first light-emitting device groups are located in different layers.

3. The display substrate according to claim 1 or 2, wherein orthographic projections of the M wires in the same wire group on a plane where the display substrate is located do not overlap.

4. The display substrate according to any one of claims 1 to 3, wherein a length of the ith wire among the M wires in the same wire group and a distance between the ith first light-emitting device and the ith first pixel circuit are equal or differ by a preset length.

5. The display substrate according to any one of claims 1 to 4, wherein a sequence of lengths of the M wires is in an arithmetic progression.

6. The display substrate according to any one of claims 1 to 5, wherein a Pth first light-emitting device group is electrically connected to an (N-P+1)th first pixel circuit group through a corresponding wire group, P being in a range of 1 to N, inclusive.

7. The display substrate according to any one of claims 1 to 6, wherein the display substrate comprises: two repeating units located in the first display region and arranged sequentially in the first direction, wherein each repeating unit includes N first light-emitting device groups; the two repeating units are respectively located on two sides of a reference line; and the reference line is a straight line extending in a second direction and passing through the first display region, the second direction being perpendicular to the first direction;
first pixel circuit groups electrically connected to the two repeating units are located on two sides of the first display region in the first direction, respectively; and
wire groups electrically connected to the two repeating units are located on the two sides of the reference line, respectively;
wherein the first display region has a center, and the reference line passes through the center.

8. The display substrate according to claim 7, wherein the two repeating units each include the same number of first light-emitting device groups.

9. The display substrate according to claim 7 or 8, wherein wires electrically connected to a jth first light-emitting device group in each repeating unit are located in the same layer; and j is in a range of 1 to N, inclusive.

10. The display substrate according to any one of claims 7 to 9, wherein the display substrate comprises: two columns of repeating units located in the first display region and arranged sequentially in the first direction, wherein each column of repeating units includes: at least two rows of repeating units arranged sequentially in the second direction;
first pixel circuit groups electrically connected to the same column of repeating units are located on the same side of the first display region and arranged sequentially in the second direction; and
wire groups electrically connected to the same column of repeating units are arranged sequentially in the second direction.

11. The display substrate according to claim 10, wherein in the same column of repeating units, a wire group electrically connected to a jth first light-emitting device group in each row of repeating units is located in the same layer; and j is in a range of 1 to N, inclusive.

12. The display substrate according to any one of claims 1 to 11, wherein a number of first light-emitting devices included in each first light-emitting device group is the same.

13. The display substrate according to any one of claims 1 to 12, wherein the first light-emitting device group and the first pixel circuit group electrically connected thereto are arranged in the same row; and
a main body portion of each wire in the wire group extends in the first direction.

14. The display substrate according to any one of claims 1 to 13, wherein the display substrate comprises:
a substrate;
a pixel circuit layer disposed on a side of the substrate, wherein the N first pixel circuit groups are located in the pixel circuit layer;
a light-emitting device layer disposed on a side of the pixel circuit layer away from the substrate, wherein the N first light-emitting device groups are located in the light-emitting device layer; and
a plurality of wire layers disposed between the pixel circuit layer and the light-emitting device layer and stacked in sequence;
wherein one wire group is located in one wire layer; and
a material of the plurality of wire layers includes a light-transmissive conductive material.

15. The display substrate according to claim 14, wherein a number of the plurality of wire layers is the same as a number of the N first light-emitting device groups.

16. The display substrate according to any one of claims 1 to 15, further comprising:
a plurality of second pixel circuits located in the second display region, wherein in the first pixel circuit group, at least one second pixel circuit is disposed between two adjacent first pixel circuits; and
a plurality of second light-emitting devices located in the second display region and electrically connected to the plurality of second pixel circuits.

17. A display module, comprising the display substrate according to any one of claims 1 to 16; and
an image acquisition device disposed on a non-light-exiting side of the display substrate and located in the first display region of the display substrate.

18. A display apparatus, comprising the display module according to claim 17.
